# EUROPEAN PATENT SPECIFICATION

(11) **EP 4 585 662 B1**
(45) Date of publication and mention of the grant of the patent: **04.11.2026**
(21) Application number: 24866647.1
(22) Date of filing: 31.05.2024
(51) Int. Cl.: C09J 163/00, C08G 59/32, C09J 11/04, C09J 11/06

(54) **ADJUSTABLE UNDERFILL ADHESIVE AND PREPARATION METHOD THEREFOR, AND CHIP PACKAGING STRUCTURE**
EINSTELLBARER UNTERFÜLLUNGSKLEBSTOFF, HERSTELLUNGSVERFAHREN DAFÜR UND CHIPVERPACKUNGSSTRUKTUR
ADHÉSIF DE SOUS-REMPLISSAGE RÉGLABLE ET SON PROCÉDÉ DE PRÉPARATION, STRUCTURE D'ENCAPSULATION DE PUCE

(30) Priority: 03.11.2023 CN 202311455335
(43) Date of publication of application: 16.07.2025
(73) Proprietor: Wuhan Choice Technology Co., Ltd., Wuhan, Hubei 430000 (CN)
(72) Inventor: WU, De, Wuhan, Hubei 430000 (CN); CAO, Dongping, Wuhan, Hubei 430000 (CN); LIAO, Shuhang, Wuhan, Hubei 430000 (CN); SU, Junxing, Wuhan, Hubei 430000 (CN)
(74) Representative: Chung, Hoi Kan
(86) International application number: PCT/CN2024/096689
(87) International publication number: WO 2025/091894

(56) References cited:
- CN-A- 1 282 105
- CN-A- 101 760 160
- CN-A- 104 962 224
- CN-A- 105 462 531
- CN-A- 115 404 025
- CN-A- 117 186 820
- JP-A- 2004 027 025
- US-A1- 2012 172 495

## Description

### TECHNICAL FIELD

The present invention belongs to the technical field of underfill adhesive packaging, and particularly relates to an adjustable underfill adhesive, a preparation method thereof, and a chip packaging structure.

### BACKGROUND

An underfill adhesive is a material suitable for an underfill technology of flip chips, is generally permeated into a gap between a chip and a substrate by using a capillary action principle, and is then gradually solidified by thermal curing and filled in the gap between the chip and the substrate, so as to protect high-density solder bumps between the chip and the substrate and the chip. However, an adhesion force between an underfill material formed after an existing underfill adhesive is cured and the chip, the substrate and the solder bumps is not strong enough, a coefficient of linear thermal expansion is too high, and a glass transition temperature is not enough, so that the underfill material is often cracked or peeled off from the chip, the substrate and/or the solder bumps, and the chip cannot be continuously protected, thus causing the chip to be damaged. CN105462531A discloses underfill compositions comprising as epoxy resin 4,5-epoxycyclohexane-1,2-dicarboxylic acid diglycidyl ester.

The glass transition temperature (Glass Transition Temperature, Tg) is one of key properties of a material, is a temperature at which the material changes from a glassy state to a highly elastic state, and is a lowest temperature at which a molecular chain segment can move. In a use process of an adhesive material, both the use and processing temperature of the adhesive material can be influenced by a too low or too high glass transition temperature, and the glass transition temperature is controlled between 90°C and 180°C, which has important significance for the use and processing of the adhesive material.

Therefore, how to provide an adjustable underfill adhesive to enhance a protection effect on the chip is a technical problem that needs to be solved urgently by those skilled in the art.

### SUMMARY

The present invention aims to provide an adjustable underfill adhesive, a preparation method thereof, and a chip packaging structure, as detailed in the appended claims, so as to solve at least one of the above-mentioned technical problems.

To achieve the above object, a first aspect of the present invention provides an adjustable underfill adhesive, which includes the following components in mass percent: 21% - 28% of trifunctional epoxy resin, 8% - 19% of amine curing agent, 54% - 66% of filler, 0.2% - 0.4% of accelerator, 0.1% - 0.3% of silane coupling agent, and 0.1% - 0.2% of carbon black. A molar ratio of the trifunctional epoxy resin to the amine curing agent is 1:0.7 - 1:1.4.

In the first aspect, a structural formula of the trifunctional epoxy resin is as follows:

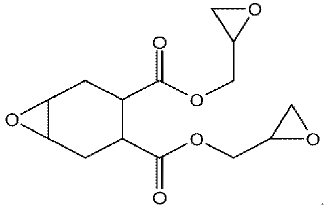

In the first aspect, the amine curing agent includes at least one of triethylenetetramine, diethyltoluenediamine, and m-phenylenediamine.

In the first aspect, the filler can include silicon dioxide, and an average particle diameter of the silicon dioxide is 0.6 µm to 3 µm;
In the first aspect, the accelerator includes an imidazole accelerator.

In the first aspect, the silane coupling agent includes at least one of γ-aminopropyl trimethoxysilane and γ-aminopropyl triethoxysilane.

In the first aspect, a mass percent of the silicon dioxide is 60% - 65%, a mass percent of the imidazole accelerator is 0.2%, a mass percent of the silane coupling agent is 0.2%, and a mass percent of the carbon black is 0.1%.

A second aspect of the present invention provides a preparation method of the adjustable underfill adhesive according to the first aspect. The preparation method includes: S1: stirring and mixing components according to respective mass percent to obtain first slurry, where the mass percent of the components specifically includes: 21% - 28% of trifunctional epoxy resin, 8% - 19% of amine curing agent, 54% - 66% of filler, 0.2% - 0.4% of accelerator, 0.1% - 0.3% of silane coupling agent, and 0.1% - 0.2% of carbon black; S2: transferring the first slurry to a three-roller grinder for dispersion treatment to obtain uniformly dispersed second slurry; and S3: carrying out vacuum defoaming on the second slurry to obtain the underfill adhesive.

In the second aspect, a molar ratio of the trifunctional epoxy resin to the amine curing agent is 1:0.7 - 1:1.4.

A third aspect of the present invention provides a chip packaging structure, including a substrate, a chip arranged on the substrate, and a plurality of solder bumps arranged at intervals, where the solder bumps are arranged between the substrate and the chip and electrically connected with the substrate and the chip, and a gap is formed between the substrate and the chip: disposing an adhesive liquid of the adjustable underfill adhesive according to the first aspect at an edge of the substrate such that the adhesive liquid of the underfill adhesive flows from one end of the gap to the other end of the gap by a capillary action, so as to fill the gap; curing the adhesive liquid of the underfill adhesive at 165°C for 2h; and after the curing is finished, obtaining the chip packaging structure.

### BENEFICIAL EFFECTS:

The adjustable underfill adhesive provided in the present invention includes the following components in mass percent: 21% - 28% of trifunctional epoxy resin, 8% - 19% of amine curing agent, 54% - 66% of filler, 0.2% - 0.4% of accelerator, 0.1% - 0.3% of silane coupling agent, and 0.1% - 0.2% of carbon black. A molar ratio of the trifunctional epoxy resin to the amine curing agent is 1:0.7 - 1:1.4. When the molar ratio of the trifunctional epoxy resin to the amine curing agent is equal to 1:1, epoxy groups and amino groups are completely reacted to form a thermosetting resin, which has a maximum crosslinking density and a maximum glass transition temperature. The glass transition temperature of the underfill adhesive can be controlled between 90°C and 180°C by controlling the molar ratio of the trifunctional epoxy resin to the amine curing agent to be 1:0.7 - 1:1.4. In addition, the silane coupling agent is introduced, so that a bonding degree between the filler and the thermosetting epoxy resin is improved, the stability of the underfill adhesive is further improved, and an organic matrix-silane coupling agent-inorganic matrix bonding layer can be formed between an inorganic interface and an organic interface, which improves a bonding strength of the underfill adhesive, and further enhances a protection effect on a chip.

### BRIEF DESCRIPTION OF THE DRAWINGS

To illustrate the technical solutions in the embodiments of the present invention or in the prior art more clearly, the following briefly introduces the accompanying drawings to be used for describing the embodiments. Obviously, the accompanying drawings in the following description only show some embodiments of the present invention, and those skilled in the art may still derive other accompanying drawings from these accompanying drawings without creative efforts.

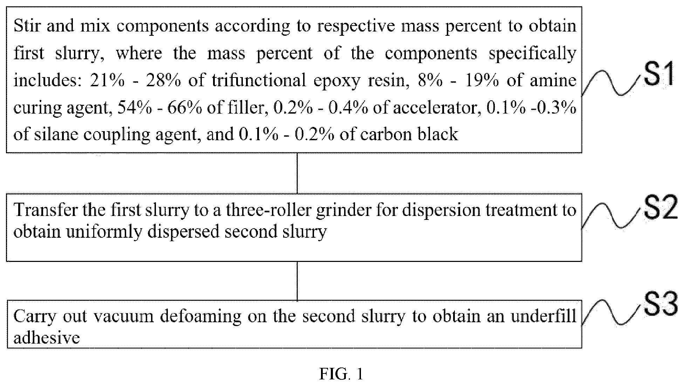

FIG. 1 is a flowchart of a preparation method of an adjustable underfill adhesive according to the present invention.

### DETAILED DESCRIPTION OF THE EMBODIMENTS

The present invention will be described in detail in combination with specific implementations and embodiments, from which the advantages and various effects of the present invention will be presented more clearly. Those skilled in the art should understand that these specific implementations and embodiments are used to illustrate the present invention, but not to limit the present invention.

Throughout the description, unless otherwise specified, the terms used herein should be understood as having meanings commonly used in the art. Therefore, unless otherwise defined, all technical and scientific terms used herein have the same meanings as those commonly understood by those skilled in the art to which the present invention belongs. If there is a conflict, the description takes precedence.

Unless otherwise specified, various raw materials, reagents, instruments, devices, etc. used in the present invention can be purchased from the market or can be prepared by existing methods.

The present invention provides an adjustable underfill adhesive, including the following components in mass percent: 21% - 28% of trifunctional epoxy resin, 8% - 19% of amine curing agent, 54% - 66% of filler, 0.2% - 0.4% of accelerator, 0.1% - 0.3% of silane coupling agent, and 0.1% - 0.2% of carbon black, where a molar ratio of the trifunctional epoxy resin to the amine curing agent is 1:0.7 - 1:1.4.

The adjustable underfill adhesive provided in the present invention includes the following components in mass percent: 21% - 28% of trifunctional epoxy resin, 8% - 19% of amine curing agent, 54% - 66% of filler, 0.2% - 0.4% of accelerator, 0.1% - 0.3% of silane coupling agent, and 0.1% - 0.2% of carbon black. A molar ratio of the trifunctional epoxy resin to the amine curing agent is 1:0.7 - 1:1.4. When the molar ratio of the trifunctional epoxy resin to the amine curing agent is equal to 1:1, epoxy groups and amino groups are completely reacted to form a thermosetting resin, which has a maximum crosslinking density and a maximum glass transition temperature. The glass transition temperature of the underfill adhesive can be controlled between 90°C and 180°C by controlling the molar ratio of the trifunctional epoxy resin to the amine curing agent to be 1:0.7 - 1:1.4. In addition, the silane coupling agent is introduced, so that a bonding degree between the filler and the thermosetting epoxy resin is improved, the stability of the underfill adhesive is further improved, and an organic matrix-silane coupling agent-inorganic matrix bonding layer can be formed between an inorganic interface and an organic interface, which improves a bonding strength of the underfill adhesive, and further enhances a protection effect on a chip.

A structural formula of the trifunctional epoxy resin is as follows:

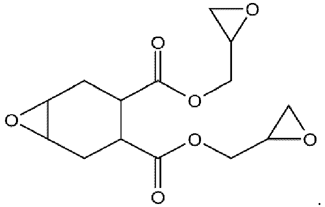

The trifunctional group is used as a material matrix to provide adhesion and mechanical properties for the underfill adhesive. The trifunctional epoxy resin is commercially available, for example, TDE-85 from Jining Fangyu Chemical Co. Ltd. (epoxy equivalent weight of 100-125 g/eq), and CY-186 from Guangzhou Yihunsheng Chemical Co. Ltd. (epoxy equivalent weight of 100-110 g/eq).

In some possible embodiments, the amine curing agent includes at least one of triethylene tetramine, diethyltoluenediamine, and m-phenylenediamine.

The amine curing agent reacts with the trifunctional epoxy resin under the action of a certain temperature and accelerator, and a thermosetting compound with a three-dimensional network structure is generated via a curing reaction. The amine curing agent may be any of triethylene tetramine (active hydrogen equivalent weight of 48 g/eq), diethyltoluenediamine (active hydrogen equivalent weight of 45 g/eq), and m-phenylenediamine (active hydrogen equivalent weight of 27 g/eq).

A reaction mechanism of the amine curing agent and the trifunctional epoxy resin:

When a molar ratio of the epoxy resin to the curing agent is greater than 1:1, epoxy groups are excessive, a concentration of amino groups is lower, the amino groups and epoxy groups are condensed in a curing process, there are still redundant epoxy groups that do not participate in the reaction after the condensation reaction is finished, and a crosslinking density is lower than that of the epoxy groups in the complete reaction, so that the Tg of a cured product is smaller, the heat released in the curing process is low, and the temperature required by homopolymerization of the residual epoxy groups is not reached, therefore, the redundant epoxy groups do not participate in the reaction, and the final Tg is smaller.

When a molar ratio of the epoxy resin to the curing agent is equal to 1:1, the amino groups and epoxy groups are reacted completely, the crosslinking density is maximum, and the Tg reaches the maximum.

When a molar ratio of the epoxy resin to the curing agent is less than 1:1, amino groups are excessive, a concentration of amino groups is higher, the amino groups and epoxy groups are condensed in a curing process, the heat released in the curing process is high, the temperature required by the homopolymerization of the epoxy resin groups is reached, and meanwhile, some epoxy groups are homopolymerized, which makes the crosslinking density smaller, the chain segment longer and the final Tg smaller.

Based on this, the present invention achieves control of the glass transition temperature of the underfill adhesive by controlling the molar ratio of the trifunctional epoxy resin to the amine curing agent.

In some possible embodiments, the filler includes silicon dioxide, and an average particle diameter of the silicon dioxide is 0.6 µm to 3 µm.

As an inorganic filler, the silicon dioxide can reduce a coefficient of thermal expansion of a cured product and change a modulus of a material.

In some possible embodiments, the accelerator includes an imidazole accelerator.

The accelerator can accelerate a reaction rate of the trifunctional epoxy resin and the amine curing agent, reduce a curing time, and improve a production efficiency. The accelerator may be an imidazole accelerator, and preferably, the imidazole accelerator may be at least one of 4-methyl-2-phenylimidazole and 2-ethyl-4-methylimidazole.

The silane coupling agent includes at least one of γ-aminopropyl trimethoxysilane and γ-aminopropyl triethoxysilane.

The silane coupling agent can promote connection among the underfill adhesive, a substrate, and a passivation layer of SiO₂ or Si₃N₄ on a chip surface, and improve a bonding strength and stability between the underfill adhesive and a substrate surface. In the present invention, the silane coupling agent includes at least one of γ-aminopropyl trimethoxysilane and γ-aminopropyl triethoxysilane, has one active primary amino functional group and three hydrolyzable methoxy groups or ethoxy groups. The primary amino functional group can react with an organic substance (epoxy group) to combine, and the methoxy groups or ethoxy groups are hydrolyzed to generate silanol and combine with an inorganic substance to form siloxane. This dual reactivity enables the silane coupling agent to improve the bonding degree between inorganic materials (fillers) and organic polymers (thermosetting resins) through a two-way chemical reaction of the two, thus improving the stability of the underfill adhesive.

In some possible embodiments, a mass percent of the silicon dioxide is 60% - 65%, a mass percent of the imidazole accelerator is 0.2%, a mass percent of the silane coupling agent is 0.2%, and a mass percent of the carbon black is 0.1%.

Based on a general inventive concept, the present invention further provides a preparation method of the adjustable underfill adhesive as described above. Referring to FIG. 1, the preparation method includes:
S1: stirring and mixing components according to respective mass percent to obtain first slurry, where the mass percent of the components specifically includes: 21% - 28% of trifunctional epoxy resin, 8% - 19% of amine curing agent, 54% - 66% of filler, 0.2% - 0.4% of accelerator, 0.1% -0.3% of silane coupling agent, and 0.1% - 0.2% of carbon black, where a stirring time is 90-180s, a rotation speed is 1100 r/min, and a revolution speed is 1450 r/min;
S2: transferring the first slurry to a three-roller grinder for dispersion treatment to obtain uniformly dispersed second slurry, where a feeding gap in the three-roller grinder is 20-45 µm, and a discharging gap is 10-25 µm; and
S3: carrying out vacuum defoaming on the second slurry to obtain the underfill adhesive, where the vacuum defoaming is carried out in a centrifugal mixer, a vacuum defoaming time is 50-100 s, a rotation speed is 1100 r/min, and a revolution speed is 1450 r/min.

As another alternative embodiment, a molar ratio of the trifunctional epoxy resin to the amine curing agent is 1:0.7 - 1:1.4.

Based on a general inventive concept, the present invention further provides a chip packaging structure, including a substrate, a chip arranged on the substrate, and a plurality of solder bumps arranged at intervals, where the solder bumps are arranged between the substrate and the chip and electrically connected with the substrate and the chip, and a gap is formed between the substrate and the chip:
disposing an adhesive liquid of the adjustable underfill adhesive according to the first aspect at an edge of the substrate such that the adhesive liquid of the underfill adhesive flows from one end of the gap to the other end of the gap by a capillary action, so as to fill the gap;
curing the adhesive liquid of the underfill adhesive at 165°C for 2h; and
after the curing is finished, obtaining the chip packaging structure.

The present application will be further illustrated below in conjunction with specific examples. It shall be understood that, these examples are used for illustrative purposes only, not intended to limit the scope of the present invention. In the examples below, measurements in the experimental methods with specific conditions unspecified are typically performed in accordance with national standards. In case of absence of the respective national standards, measurements are performed in accordance with general international standards and general conditions or in accordance with conditions suggested by manufacturers.

The components of the underfill adhesive in Examples 1 to 6 and Comparative Examples 1 to 3 are shown in Table 1 below in mass percent:

**Table 1 Raw material components in mass percent**

| Component | Comparat ive Example 1 | Comparat ive Example 2 | Comparat ive Example 3 | Exam ple 1 | Exam ple 2 | Exam ple 3 | Exam ple 4 | Exam ple 5 | Exam ple 6 |
|---|---|---|---|---|---|---|---|---|---|
| Molar ratio of CY-186 to triethylene tetramine | 1:0.65 | 1:1.50 | 1:0.95 | 1:0.75 | 1:0.85 | 1:0.95 | 1:1.00 | 1:1.25 | 1:1.40 |
| CY-186 | 28 | 26 | 24.5 | 27 | 25 | 25 | 24.5 | 25 | 22.5 |
| Triethylene tetramine | 8.5 | 18 | 11.5 | 9.5 | 10 | 11 | 11.5 | 14.5 | 14.5 |
| Silicon dioxide | 63 | 55.5 | 63.5 | 63 | 64.5 | 63.5 | 63.5 | 60 | 62.5 |
| 4-methyl-2-phenylimida zole | 0.4 | 0.4 | 0.4 | 0.2 | 0.2 | 0.2 | 0.2 | 0.2 | 0.2 |
| KH540 | - | - | - | 0.2 | 0.2 | 0.2 | 0.2 | 0.2 | 0.2 |
| Carbon black | 0.1 | 0.1 | 0.1 | 0.1 | 0.1 | 0.1 | 0.1 | 0.1 | 0.1 |

The underfill adhesives provided in Examples 1 to 6 and Comparative Examples 1 to 3 were tested for a storage modulus, a glass transition temperature, a coefficient of thermal expansion, a reaction enthalpy change, a viscosity growth rate, and a fluidity, and a specific test process is as follows:
1. Storage modulus: reference standard: ASTM E2254-2018, taking a sample cured completely at 165°C for 2h, preparing a test sample with a size of 55 mm×10 mm×2 mm, measuring the sample by DMA; measuring mode: dual cantilever mode; vibration frequency: 1 Hz; amplitude: 10 µm; heating rate: 5°C/min; and the storage modulus was measured at 25°C-245°C.
2. Glass transition temperature Tg: reference standard: ASTM E2254-2018, taking a sample cured completely at 165°C for 2h, preparing a test sample with a size of 55 mm×10 mm×2 mm, measuring sample by DMA; measuring mode: dual cantilever mode; vibration frequency: 1 Hz; amplitude: 10 µm; and heating rate: 5 °C/min.
3. Coefficient of thermal expansion: reference standard: ASTM E831-2019, taking a sample cured completely at 165°C for 2h, and preparing a test sample with a size of 5 mm×5 mm×2 mm. The coefficient of thermal expansion of the sample was tested by TMA (compression mode). Parameter setting of the TMA: preloading force: 0.05 N, first scanning: room temperature -220°C (heating rate of 10°C/min); second scanning: taking curve data of a second heating segment at room temperature -220°C (heating rate of 10°C/min); and the coefficients of thermal expansion CTE1/2 were measured at 50°C-90°C and 160°C-200°C respectively.
4. Reaction enthalpy change: a DSC instrument is used for testing, reference standard: GB/T19466.3/ISO11357-3, taking 5-10 mg samples (the adhesive liquid prepared by the above components according to a proportion), and heating rate: 10 °C/min at room temperature -250°C.
5. Viscosity growth rate: measured by a digital display rotary viscosimeter (14# rotor, revolution of 20 r/min, measured at room temperature).
6. A fluidity test method: four corners of a square glass sheet with a size of 20 mm×20 mm and a thickness of 0.5 mm were stuck on a glass slide by using a double-sided adhesive with a thickness of 50 um, the glass slide was placed on an electric heating plate of 90°C for preheating three minutes, the to-be-measured underfill adhesive was transversely smeared along one edge of the square glass sheet by using a thin steel needle, and timing was started at the same time, under the action of a capillary force, the underfill adhesive can flow at the bottom of the glass sheet, and the time when the underfill adhesive flows to half the length (10 mm) of the edge and the time when the underfill adhesive flows to the full length (20 mm) of the edge were recorded.

Test results were shown in Tables 2 to 3:

**Table 2 Test Results**

| Test items | Storage modulus (GPa) | Tg (°C) | CTE1/2 | Viscosity growth rate at room temperature for 24h (%) | 10/20 mm flowing time (s) |
|---|---|---|---|---|---|
| Comparative Example 1 | 6.2/0.06 | 85.9 | 34.2/95.6 | 422.3 | 126/580 |
| Comparative Example 2 | 6.8/0.03 | 84.3 | 36.1/94.5 | 425.6 | 150/651 |
| Comparative Example 3 | 6.5/0.07 | 144.6 | 26.7/72.9 | 319.1 | 82/269 |
| Example 1 | 5.1/0.11 | 90.5 | 28.8/86.2 | 53.6 | 45/152 |
| Example 2 | 5.9/0.02 | 121.7 | 27.7/89.1 | 65.8 | 38/124 |
| Example 3 | 6.4/0.07 | 146.1 | 26.5/71.9 | 35.2 | 39/194 |
| Example 4 | 7.2/0.06 | 180.5 | 20.7/60.4 | 22.4 | 51/158 |
| Example 5 | 6.1/0.02 | 139.1 | 28.1/73.3 | 42.6 | 36/137 |
| Example 6 | 6.4/0.07 | 115.6 | 25.3/89.2 | 51.3 | 55/167 |

**Table 3 DSC Test Results**

| Test items | First Peak | | Second Peak | |
|---|---|---|---|---|
| | ΔHexo(J/g) | Tmax(°C) | ΔHexo(J/g) | Tmax(°C) |
| Comparative Example 1 | 60.4 | 196.3 | 0 | - |
| Comparative Example 2 | 102.3 | 195.5 | 12.8 | 211.5 |
| Comparative Example 3 | 78.6 | 194.1 | 0 | - |
| Example 1 | 73.1 | 196.1 | 0 | - |
| Example 2 | 78.3 | 194.7 | 0 | - |
| Example 3 | 79.7 | 195.1 | 0 | - |
| Example 4 | 91.8 | 195.2 | 0 | - |
| Example 5 | 102.2 | 196.5 | 13.4 | 210.1 |
| Example 6 | 102.0 | 194.8 | 12.6 | 212.4 |

It can be learned from the above tables that:
(1) In Comparative Example 1, the molar ratio of CY-186 to triethylene tetramine was greater than 1:1, the epoxy groups were excessive, the concentration of the amino groups was lower, and the reaction heat was low, so that there was redundant CY-186 that did not react, and the final Tg was less than 90°C; the viscosity of the underfill adhesive prepared by using the proportion of Comparative Example 1 was unstable after the silane coupling agent was not added and the viscosity was quickly increased at room temperature for 24h; the adhesive liquid of the prepared underfill adhesive was transversely smeared along one edge of the square glass sheet, the adhesive liquid flowed at the bottom of the glass sheet under the action of the capillary force, 126s was taken when the adhesive liquid flowed to 10 mm, 580s was taken when the adhesive liquid flowed to 20mm, and therefore, the fluidity of the adhesive liquid was poor;
(2) In Comparative Example 2, the molar ratio of CY-186 to triethylene tetramine is less than 1:1, the amino groups were excessive, the concentration of the amino groups was higher, the amino groups and epoxy groups were condensed in a curing process, the heat released in the curing process was high, the temperature required by the homopolymerization of the epoxy groups was reached, and meanwhile, some epoxy groups were homopolymerized, which makes the crosslinking density smaller, the chain segment longer and the final Tg less than 90°C; the viscosity of the underfill adhesive prepared by using the proportion of Comparative Example 2 was unstable after the silane coupling agent was not added and the viscosity was quickly increased at room temperature for 24h; and through the fluidity test, the fluidity of the adhesive liquid was poor;
(3) In Comparative Example 3, the molar ratio of CY-186 to triethylene tetramine was 1:0.95, the Tg was between 90°C and 180°C, the viscosity of the underfill adhesive prepared by using the proportion of Comparative Example 3 was unstable after the silane coupling agent was not added and the viscosity was quickly increased at room temperature for 24h; and through the fluidity test, the fluidity of the adhesive liquid was poor;
(4) In Examples 1 to 3, the molar ratio of CY-186 to triethylene tetramine is greater than 1:1, the epoxy groups were excessive, the concentration of the amino groups was lower, and the reaction heat was low, so that there was redundant CY-186 that did not react, but the molar ratio of CY-186 to triethylene tetramine is more than that of Comparative Example 1, so that Tg is between 90°C and 180°C, and the silane coupling agent KH540 was added, so that the viscosity growth rate at room temperature for 24h was within 100%, namely, the underfill adhesive prepared by using Examples 1 to 3 had better stability; and when the fluidity test was conducted, it was found that the flowing time was significantly shortened, that is, the fluidity of the adhesive liquid in Examples 1 to 3 was good;
(5) In Example 4, the molar ratio of CY-186 to triethylene tetramine was equal to 1:1, the amino groups and the epoxy groups were reacted completely in this case, the crosslinking density was maximum, the Tg reached a maximum value of 180°C, the silane coupling agent KH540 was added, the viscosity growth rate at room temperature for 24h was only 22.4%, and the viscosity growth rate was minimum in Examples 1 to 6, namely, when the molar ratio of CY-186 to triethylene tetramine was equal to 1:1, the Tg reached a maximum value of 180°C, and the stability of the underfill adhesive prepared by using the proportion of Example 4 was the best; and
(6) In Examples 5 to 6, the molar ratio of CY-186 to triethylene tetramine was less than 1:1, the amino groups were excessive, the concentration of the amino groups was higher, the amino groups and the epoxy groups were condensed in a curing process, the heat released in the curing process was high, the temperature required by the homopolymerization of the epoxy groups was reached, and meanwhile, some epoxy groups were homopolymerized, which made the crosslinking density smaller, the chain segment longer and the Tg smaller, but the molar ratio of CY-186 to triethylene tetramine in Examples 5 to 6 was less than that of Comparative Example 2, so that the Tg was greater than that of Comparative Example 2; the molar ratio of CY-186 to triethylene tetramine in Examples 5 to 6 was greater than that of Example 4, so the Tg is smaller than that of Example 4, and the silane coupling agent KH540 was added in Examples 5 to 6, so that the viscosity growth rate at room temperature for 24h was within 100%, namely, the underfill adhesive prepared by using the proportion of Examples 5 to 6 had better stability.

In summary, the underfill adhesive prepared by using the proportion in Examples 1 to 6 of the present invention had better stability because the Tg was controlled to be between 90 and 180°C and the viscosity growth rate at room temperature for 24h was within 100% due to the addition of the silane coupling agent, and the underfill adhesive had excellent fluidity because the flowing time was greatly shortened compared with that of Comparative Examples 1 to 3 when the fluidity test was performed, namely, the present invention provides an adjustable underfill adhesive with high stability and excellent fluidity, and is favorable for improving a chip protection effect.

Moreover, the terminology "comprising", "including" or any other alterations are intended to cover non-exclusive inclusion, so as to make a process, method, article or apparatus including a series of elements further includes elements that are not listed explicitly other than said series of elements, or includes elements inherent to such process, method, article or apparatus.

Although the preferred embodiments of the present invention have been described, those skilled in the art benefiting from the underlying inventive concept can make additional modifications and variations to these embodiments. Therefore, the appended claims are intended to be construed as encompassing the embodiments and all the modifications and variations falling in the scope of the present invention.

Apparently, various modifications and variations to the present invention can be made by those skilled in this art without departing from the scope of the present invention Thereby, the present invention intends to encompass all such modifications and variations within the scope of the claims of the present invention.

## Claims

1. An adjustable underfill adhesive, **characterized by** comprising the following components in mass percent: 21% - 28% of trifunctional epoxy resin, 8% - 19% of amine curing agent, 54% - 66% of filler, 0.2% - 0.4% of accelerator, 0.1% - 0.3% of silane coupling agent, and 0.1% - 0.2% of carbon black, wherein a molar ratio of the trifunctional epoxy resin to the amine curing agent is 1:0.7 - 1:1.4;
the silane coupling agent comprises at least one of γ-aminopropyl trimethoxysilane and γ-aminopropyl triethoxysilane; and
a structural formula of the trifunctional epoxy resin is as follows:

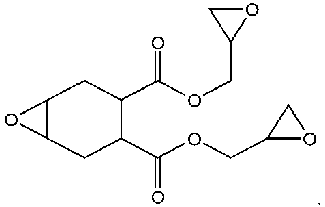

2. The adjustable underfill adhesive according to claim 1, **characterized in that** the amine curing agent comprises at least one of triethylene tetramine, diethyltoluenediamine, and m-phenylenediamine.

3. The adjustable underfill adhesive according to claim 2, **characterized in that** the accelerator comprises an imidazole accelerator.

4. The adjustable underfill adhesive according to claim 3, **characterized in that** the filler comprises silicon dioxide, and a mass percent of the silicon dioxide is 60% - 65%, a mass percent of the imidazole accelerator is 0.2%, a mass percent of the silane coupling agent is 0.2%, and a mass percent of the carbon black is 0.1%.

5. A preparation method of the adjustable underfill adhesive according to any one of claims 1 to 4, **characterized in that** the preparation method comprises:
S1: stirring and mixing components according to respective mass percent to obtain first slurry, wherein the mass percent of the components specifically comprises: 21% - 28% of trifunctional epoxy resin, 8% - 19% of amine curing agent, 54% - 66% of filler, 0.2% - 0.4% of accelerator, 0.1% - 0.3% of silane coupling agent, and 0.1% - 0.2% of carbon black;
S2: transferring the first slurry to a three-roller grinder for dispersion treatment to obtain uniformly dispersed second slurry; and
S3: carrying out vacuum defoaming on the second slurry to obtain the underfill adhesive.

6. The preparation method according to claim 5, **characterized in that** a molar ratio of the trifunctional epoxy resin to the amine curing agent is 1:0.7 - 1:1.4.

7. A chip packaging structure, **characterized by** comprising a substrate, a chip arranged on the substrate, and a plurality of solder bumps arranged at intervals, wherein the solder bumps are arranged between the substrate and the chip and electrically connected with the substrate and the chip, and a gap is formed between the substrate and the chip, **characterized by**:
disposing an adhesive liquid of the adjustable underfill adhesive according to any one of claims 1 to 4 at an edge of the substrate such that the adhesive liquid of the underfill adhesive flows from one end of the gap to the other end of the gap by a capillary action, so as to fill the gap;
curing the adhesive liquid of the underfill adhesive at 165°C for 2h; and
after the curing is finished, obtaining the chip packaging structure.

## Patentansprüche

1. Einstellbarer Underfill-Klebstoff, **dadurch gekennzeichnet, dass** er die folgenden Komponenten in Massenprozent umfasst: 21 % bis 28 % trifunktionelles Epoxidharz, 8 % bis 19 % Aminhärter, 54 % bis 66 % Füllstoff, 0,2 % bis 0,4 % Beschleuniger, 0,1 % bis 0,3 % Silan-Haftvermittler und 0,1 % bis 0,2 % Ruß, wobei ein Molverhältnis des trifunktionellen Epoxidharzes zu dem Aminhärter 1:0,7 bis 1:1,4 beträgt;
wobei der Silan-Haftvermittler mindestens eines von γ-Aminopropyltrimethoxysilan und γ-Aminopropyltriethoxysilan umfasst; und
wobei eine Strukturformel des trifunktionellen Epoxidharzes wie folgt ist:

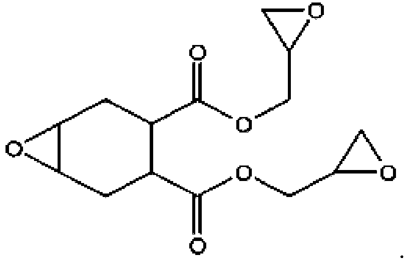

2. Einstellbarer Underfill-Klebstoff nach Anspruch 1, **dadurch gekennzeichnet, dass** der Aminhärter mindestens eines von Triethylentetramin, Diethyltoluoldiamin und m-Phenylendiamin umfasst.

3. Einstellbarer Underfill-Klebstoff nach Anspruch 2, **dadurch gekennzeichnet, dass** der Beschleuniger einen Imidazol-Beschleuniger umfasst.

4. Einstellbarer Underfill-Klebstoff nach Anspruch 3, **dadurch gekennzeichnet, dass** der Füllstoff Siliziumdioxid umfasst und ein Massenprozentsatz des Siliziumdioxids 60 % bis 65 % beträgt, ein Massenprozentsatz des Imidazol-Beschleunigers 0,2 % beträgt, ein Massenprozentsatz des Silan-Haftvermittlers 0,2 % beträgt und ein Massenprozentsatz des Rußes 0,1 % beträgt.

5. Verfahren zum Herstellen des einstellbaren Underfill-Klebstoffs nach einem der Ansprüche 1 bis 4, **dadurch gekennzeichnet, dass** das Verfahren zum Herstellen Folgendes umfasst:
S1: Rühren und Mischen von Komponenten gemäß den jeweiligen Massenprozenten, um eine erste Aufschlämmung zu erhalten, wobei der Massenprozentsatz der Komponenten spezifisch Folgendes umfasst: 21 % bis 28 % trifunktionelles Epoxidharz, 8 % bis 19 % Aminhärter, 54 % bis 66 % Füllstoff, 0,2 % bis 0,4 % Beschleuniger, 0,1 % bis 0,3 % Silan-Haftvermittler und 0,1 % bis 0,2 % Ruß;
S2: Überführen der ersten Aufschlämmung in einen Dreiwalzenstuhl zur Dispersionsbehandlung, um eine gleichmäßig dispergierte zweite Aufschlämmung zu erhalten; und
S3: Durchführen einer Vakuumentschäumung an der zweiten Aufschlämmung, um den Underfill-Klebstoff zu erhalten.

6. Verfahren zum Herstellen nach Anspruch 5, **dadurch gekennzeichnet, dass** ein Molverhältnis des trifunktionellen Epoxidharzes zu dem Aminhärter 1:0,7 bis 1:1,4 beträgt.

7. Chip-Gehäusestruktur, **dadurch gekennzeichnet, dass** sie Folgendes umfasst: ein Substrat, einen auf dem Substrat angeordneten Chip und eine Vielzahl von Lotkontakthügeln, die in Abständen angeordnet sind, wobei die Lotkontakthügel zwischen dem Substrat und dem Chip angeordnet sind und mit dem Substrat und dem Chip elektrisch verbunden sind und ein Spalt zwischen dem Substrat und dem Chip gebildet ist, **gekennzeichnet durch**:
Aufbringen einer Klebstoffflüssigkeit des einstellbaren Underfill-Klebstoffs nach einem der Ansprüche 1 bis 4 an einem Rand des Substrats, sodass die Klebstoffflüssigkeit des Underfill-Klebstoffs von einem Ende des Spalts zu dem anderen Ende des Spalts durch eine Kapillarwirkung fließt, um den Spalt zu füllen;
Aushärten der Klebstoffflüssigkeit des Underfill-Klebstoffs bei 165 °C für 2 h; und
Erhalten der Chip-Gehäusestruktur, nachdem das Aushärten abgeschlossen ist.

## Revendications

1. Adhésif de sous-remplissage réglable, **caractérisé en ce qu'**il comprend les composants suivants en pourcentage massique : 21 % - 28 % de résine époxy trifonctionnelle, 8 % - 19 % d'agent de durcissement amine, 54 % - 66 % de charge, 0,2 % - 0,4 % d'accélérateur, 0,1 % - 0,3 % d'agent de couplage silane, et 0,1 % - 0,2 % de noir de carbone, dans lequel un rapport molaire de la résine époxy trifonctionnelle à l'agent de durcissement amine est de 1:0,7 - 1:1,4 ;
l'agent de couplage silane comprend au moins l'un parmi le γ-aminopropyl triméthoxysilane et le γ-aminopropyl triéthoxysilane ; et
une formule structurelle de la résine époxy trifonctionnelle est comme suit :

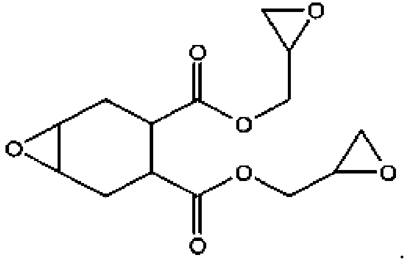

2. Adhésif de sous-remplissage réglable selon la revendication 1, **caractérisé en ce que** l'agent de durcissement amine comprend au moins l'une parmi la triéthylène tétramine, la diéthyltoluènediamine et la m-phénylènediamine.

3. Adhésif de sous-remplissage réglable selon la revendication 2, **caractérisé en ce que** l'accélérateur comprend un accélérateur d'imidazole.

4. Adhésif de sous-remplissage réglable selon la revendication 3, **caractérisé en ce que** la charge comprend du dioxyde de silicium, et un pourcentage massique du dioxyde de silicium est de 60 % - 65 %, un pourcentage massique de l'accélérateur d'imidazole est de 0,2 %, un pourcentage massique de l'agent de couplage silane est de 0,2 %, et un pourcentage massique du noir de carbone est de 0,1 %.

5. Procédé de préparation de l'adhésif de sous-remplissage réglable selon l'une quelconque des revendications 1 à 4, **caractérisé en ce que** le procédé de préparation comprend :
S1 : brassage et mélange des composants selon un pourcentage massique respectif pour obtenir une première suspension, dans lequel le pourcentage massique des composants comprend spécifiquement : 21 % - 28 % de résine époxy trifonctionnelle, 8 % - 19 % d'agent de durcissement amine, 54 % - 66 % de charge, 0,2 % - 0,4 % d'accélérateur, 0,1 % - 0,3 % d'agent de couplage silane, et 0,1 % - 0,2 % de noir de carbone ;
S2 : transfert de la première suspension vers un broyeur à trois rouleaux pour un traitement de dispersion pour obtenir une deuxième suspension uniformément dispersée ; et
S3 : réalisation d'un démoussage sous vide sur la deuxième suspension pour obtenir l'adhésif de sous-remplissage.

6. Procédé de préparation selon la revendication 5, **caractérisé en ce qu'**un rapport molaire de la résine époxy trifonctionnelle à l'agent de durcissement amine est de 1:0,7 - 1:1,4.

7. Structure d'encapsulation de puce, **caractérisée en ce qu'**elle comprend un substrat, une puce agencée sur le substrat, et une pluralité de pastilles de soudure agencées à des intervalles, dans laquelle les pastilles de soudure sont agencées entre le substrat et la puce et connectées électriquement au substrat et à la puce, et un espace est formé entre le substrat et la puce, **caractérisée en ce que** :
un liquide adhésif de l'adhésif de sous-remplissage réglable selon l'une quelconque des revendications 1 à 4 est disposé au niveau d'un bord du substrat de telle sorte que le liquide adhésif de l'adhésif de sous-remplissage s'écoule à partir d'une extrémité de l'espace jusqu'à l'autre extrémité de l'espace par une action capillaire, de façon à remplir l'espace ;
le liquide adhésif de l'adhésif de sous-remplissage est durci à 165°C pendant 2h ; et
après que le durcissement est terminé, la structure d'encapsulation de puce est obtenue.
